Europäisches Patentamt

European Patent Office

Office européen des brevets

(19)

(11) **EP 0 545 787 B1**

(12) **FASCICULE DE BREVET EUROPEEN**

(45) Date de publication et mention
de la délivrance du brevet:
**20.08.1997   Bulletin 1997/34**

(51) Int Cl.[6]: **H01L 31/0352**, G02F 1/35

(21) Numéro de dépôt: **92403193.3**

(22) Date de dépôt: **26.11.1992**

(54) **Hétérostructure semiconductrice pour le traitement d'un signal optique**

Halbleiterheterostruktur für die Verarbeitung eines optischen Signals

Semiconductor heterostructure for optical signal processing

(84) Etats contractants désignés:
**DE GB**

(30) Priorité: **29.11.1991   FR 9114831**

(43) Date de publication de la demande:
**09.06.1993   Bulletin 1993/23**

(73) Titulaire: **FRANCE TELECOM**
**75015 Paris (FR)**

(72) Inventeurs:
• **Gerard, Jean-Michel**
**F-75005 Paris (FR)**
• **Marzin, Jean-Yves**
**F-91400 Orsay (FR)**

(74) Mandataire: **Dubois-Chabert, Guy et al**
**c/o BREVATOME**
**25, rue de Ponthieu**
**75008 Paris (FR)**

(56) Documents cités:
• SUPERLATTICES AND MICROSTRUCTURES vol. 8, no. 4, 1990, LONDON, GB pages 417 - 419 GERARD ET AL. 'DIFFERENTIATION OF THE NON-RADIATIVE RECOMBINATION PROPERTIES OF THE TWO INTERFACES OF MBE GROWN GaAs-GaAlAs QUANTUM WELLS'
• APPLIED PHYSICS LETTERS. vol. 56, no. 16, 16 Avril 1990, NEW YORK US pages 1555 - 1557 SATO ET AL. 'MODULATION OF QUANTIZED LEVELS OF GaAs/AlGaAs QUANTUM WELLS BY InAs MONOMOLECULAR PLANE INSERTION'
• PROCEEDINGS OF THE 13TH INTERNATIONAL SYMPOSIUM ON GALLIUM ARSENIDE AND RELATED COMPOUNDS 28 Septembre 1986, LAS VEGAS, US pages 135 - 140 TISCHLER ET AL. 'ATOMIC LAYER EPITAXY OF III-V MATERIALS AND QUANTUM WELLS STRUCTURES'
• PHYSICAL REVIEW, B. CONDENSED MATTER. vol. 41, no. 11, 15 Avril 1990, NEW YORK US pages 7678 - 7683 LEE ET AL. 'PHOTOLUMINESCENCE AND STIMULATED EMISSION FROM MONOLAYER-THICK PSEUDOMORPHIC InAs SINGLE-QUANTUM-WELL HETEROSTRUCTURES'
• APPLIED PHYSICS LETTERS. vol. 53, no. 7, 15 Août 1988, NEW YORK US pages 568 - 570 GERARD ET AL. 'HIGH QUALITY ULTRATHIN InAs/GaAs QUANTUM WELLS GROWN BY STANDARD AND LOW-TEMPERATURE MODULATED-FLUXES MOLECULAR BEAM EPITAXY'

**Description**

La présente invention concerne une hétérostructure semiconductrice qui permet une absorption intra-bande efficace d'un rayonnement électromagnétique dont la longueur d'onde est inférieure ou égale à 3 micromètres.

En d'autres termes, une hétérostructure conforme à la présente invention est capable d'absorber dans une fenêtre spectrale étroite qui est centrée sur une longueur d'onde donnée, inférieure ou égale à 3 micromètres.

L'hétérostructure objet de l'invention peut constituer le milieu actif d'un détecteur, d'un modulateur ou d'un filtre stoppe-bande fonctionnant à des longueurs d'onde inférieures ou égales à 3 micromètres, ces longueurs d'onde étant par exemple comprises entre 1,5 micromètre et 3 micromètres.

L'invention a donc des applications en optoélectronique et en particulier dans le domaine des télécommunications par fibres optiques.

Elle permet d'introduire une nouvelle famille de composants qui fonctionnent au voisinage des longueurs d'onde 1,55 micromètre et 2,5 micromètres, correspondant au minima d'atténuation des fibres optiques classiques et des fibres de nouvelle génération à base de verres fluorés.

On va d'abord rappeler le mécanisme d'absorption intra-bande dans une structure à puits quantique.

Ce mécanisme est exploité par une famille de composants semiconducteurs (détecteurs, modulateurs) qui travaillent essentiellement dans l'infrarouge lointain (longueurs d'onde de l'ordre de 10 micromètres).

Pour les structures semiconductrices connues, la longueur d'onde minimale de fonctionnement est de l'ordre de 3,5 micromètres.

La présente invention propose une hétérostructure semiconductrice qui permet d'augmenter considérablement la plage de fonctionnement efficace des dispositifs utilisant l'absorption intra-bande.

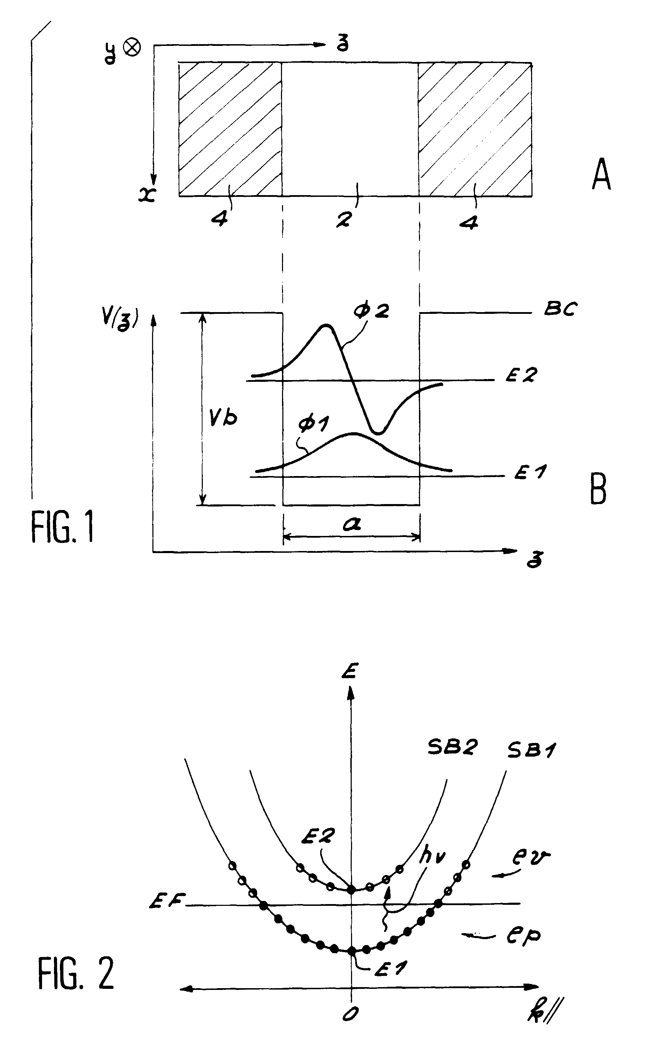

En faisant référence à la figure 1 partie A, on rappelle qu'un puits quantique est obtenu par l'insertion d'une couche mince 2 d'un matériau semiconducteur entre deux couches semiconductrices 4 dont la bande interdite a une largeur supérieure à celle de la couche 2, ces couches 4 étant appelées "couches-barrières".

On utilise en général des matériaux d'une même famille semiconductrice (III-V, II-VI ou IV) pour réaliser les couches 2 et 4.

A cause de la modulation de la composition de l'empilement ainsi obtenu, un électron placé dans la bande de conduction BC "voit" un puits de potentiel artificiel dont le profil est rappelé sur la partie B de la figure 1.

On note z la direction de l'espace suivant laquelle est réalisé l'empilement, et x et y des directions orthogonales dans le plan des couches de l'empilement.

La mécanique quantique enseigne que les états électroniques de conduction d'une telle structure se rassemblent, à cause du confinement des électrons suivants z, en plusieurs sous-bandes qui sont quasiment parallèles.

Les énergies des minima de ces sous-bandes prennent des valeurs discrètes.

Les deux premières sous-bandes sont respectivement notées SB1 et SB2 et les énergies des minima des sous-bandes SB1 et SB2 sont respectivement notées E1 et E2, avec E2 supérieur à E1.

Ceci est illustré par la figure 2 qui montre les courbes de dispersion des sous-bandes SB1 et SB2, E représentant l'énergie et k// représentant le module du vecteur d'onde d'un électron dans le plan (x, y).

On voit aussi sur la partie B de la figure 1 (où V(z) représente la valeur du potentiel en fonction de z) que la densité de probabilité de présence $|\phi 1|^2$ d'un électron de la sous-bande SB1 est forte au centre du puits quantique.

Au contraire, la densité de probabilité de présence $|\phi 2|^2$ d'un électron de la sous-bande SB2 est nulle au centre du puits.

Il est possible de peupler les niveaux de plus basse énergie du puits par des électrons, en dopant par des donneurs la couche 2 et/ou les couches-barrières 4.

On peut également photo-créer un gaz d'électrons, en excitant optiquement la structure avec un rayonnement d'énergie supérieure à la largeur de bande interdite de cette structure.

Les états de conduction sont alors peuplés jusqu'à une certaine énergie EF (niveau de Fermi), les états supérieurs restant quasiment vides.

Ceci est illustré par la figure 2 où la référence ep désigne les états de conduction peuplés et la référence ev désigne les états de conduction vides.

L'absorption intra-bande, encore appelée absorption inter-sous-bande, est une transition optique, d'un état d'une sous-bande vers un état d'une sous-bande supérieure, cette transition s'accompagnant de l'absorption d'un photon.

Cette transition nécessite que plusieurs conditions soient satisfaites:

- k// est (quasiment) conservé,
- l'énergie h.v du photon (où h représente la constante de Planck et v la fréquence de ce photon) est égale à la différence d'énergie entre le niveau initial et le niveau final,
- le niveau de départ doit être peuplé.

Ce phénomène est illustré par la figure 2.

Compte tenu du quasi-parallélisme des sous-bandes , on voit que pour une structure donnée et deux de ces sous-bandes, en général SB1 et SB2, l'absorption du rayonnement électromagnétique est résonnante pour une énergie hv égale à E2-E1.

En fait, pour des structures telles que E2-E1 soit inférieure à 0,25 eV, le pic d'absorption a une largeur finie de l'ordre de 6 à 7 meV, qui reflète le court temps de vie (temps de déphasage) de l'électron dans son état d'arrivée après absorption.

Pour des transitions à énergie plus élevée, on peut observer des effets d'élargissement qui sont dus à la non parabolicité de la bande de conduction des matériaux semiconducteurs utilisés pour réaliser le puits quantique.

On rappelle enfin qu'on définit la force d'oscillateur fij de la transition de la sous-bande SBi vers la sous-bande SBj par la formule suivante :

$$f_{ij} = (8pi^2 . m^*/h^2).(E_i-E_j). |<\phi_i|z|\phi_j>|^2$$

où pi représente le nombre bien connu qui vaut environ 3,14 et m* représente la masse effective de l'électron qui subit la transition.

Dans le cas usuel d'un puits dont la seule première sous-bande est peuplée, l'absorption totale associée à la transition de SB1 vers SBj, intégrée sur l'ensemble de la raie de résonance est proportionnelle, pour une configuration donnée d'excitation (angle d'incidence et polarisation du rayonnement électromagnétique) au produit de la force d'oscillateurs f1j par la densité de porteurs dans le puits, cette densité étant usuellement comprise entre $10^{11}$ et $10^{12}$ porteurs par cm$^2$.

On réalise usuellement des multi-puits quantiques, dans lesquels la structure absorbante est répétée une cinquantaine de fois pour augmenter le coefficient d'absorption de la structure tout en conservant une épaisseur raisonnable pour celle-ci.

Parmi les dispositifs utilisant l'absorption intra-bandes, on connaît :

- les filtres stoppe-bande,
- les détecteurs photoconducteurs à puits quantiques (voir le document (1) qui comme les autres documents cités par la suite, est mentionné à la fin de la présente description)
- les modulateurs à commande électrique dont un exemple est donné dans le document (2)
- les modulateurs à commande optique dont un exemple est donné dans le document (3).

L'ensemble de ces applications connues de l'absorption intra-bande a été développé dans la plage allant de 5 à 20 micromètres.

La présente invention vise à étendre vers les courtes longueurs d'onde la plage de fonctionnement de ces dispositifs et, pour ce faire, d'étendre la plage d'énergie dans laquelle il est possible d'obtenir une absorption intra-bande efficace.

Le document (4) montre l'intérêt des puits quantiques pour le doublage de fréquence dans l'infrarouge moyen (5 à 20 micromètres).

Cependant, la technique mentionnée dans ce document (4) ne peut être étendue à des énergies supérieures à 0,3 eV.

Il est également connu, par le document (5), d'utiliser des puits asymétriques pour réaliser une opération de génération de seconde harmonique au voisinage de leur énergie de bande interdite mais cette génération de seconde harmonique n'est pas efficace pour de grandes énergies (par exemple 0,8 eV).

Comme on le verra par la suite, certaines structures conformes à la présente invention permettent d'obtenir un fort coefficient de génération de seconde harmonique à partir d'un rayonnement proche-infrarouge (0,8 eV par exemple).

On ajoute que deux autres approches sont a priori possibles pour agrandir la plage énergétique dans laquelle il est possible d'observer une absorption intra-bande efficace.

Une première approche consiste à réduire la largeur a du puits et une deuxième approche consiste à utiliser des transitions entre SB1 et SBn, avec n supérieur à 2.

Cependant, ces approches sur lesquelles on reviendra en détail par la suite ne permettent pas d'obtenir une absorption efficace dans la plage d'énergies supérieures à 400 meV.

La présente invention vise une hétérostructure semiconductrice qui ne présente pas ces inconvénients.

L'invention permet d'augmenter l'espacement entre les sous-bandes SB1 et SB2 d'un puits quantique, et donc l'énergie de la transition intra-bande, tout en augmentant la force d'oscillateur de cette transition.

On trouve dans l'article de GERARD et al., publié dans SUPERLATTICES AND MICROSTRUCTURES vol.8, n°4, 1990, p.417 à 419, une étude de la répartition de la densité des centres de recombinaison non radiative dans un puits quantique. Les échantillons sont formés sur des substrats en GaAs. Ces échantillons consistent en des structures à multipuits quantiques contenant six puits de GaAs qui sont séparés par des barrières en AlGaAS. Dans une série d'échantillons, une monocouche de InAs est insérée un endroit déterminé dans chaque période de la structure et l'on fait varier son emplacement d'un échantillon à l'autre.

La présente invention a pour objet une hétérostructure semiconductrice conformément à la revendication 1.

Les matériaux constitutifs de la couche mince et des couches entre lesquelles cette couche mince se trouve peuvent appartenir à la même famille de matériaux semiconducteurs.

Selon un premier mode de réalisation particulier de l'hétérostructure objet de l'invention, la couche mince est en $Ga_{1-x}Al_xAs$ et les couches entre lesquelles se trouve cette couche mince sont en $Ga_{1-y}Al_yAs$, x étant positif ou nul et inférieur à y, y étant inférieur ou égal à 1.

Dans ce cas, la couche ultrafine peut être en $In_zGa_{1-z}As$, z étant supérieur à 0 et inférieur ou égal à 1.

Selon un deuxième mode de réalisation particulier, la couche mince est en $Ga_{1-x}Al_xSb$ et les couches entre lesquelles se trouve cette couche mince sont en $Ga_yAl_{1-y}Sb$, x étant positif ou nul et inférieur à y, y étant inférieur ou égal à 1.

Dans ce cas, la couche ultrafine peut être en InAs.

L'hétérostructure objet de l'invention peut être dopée par des donneurs, de façon à peupler par des électrons le bas de la sous-bande dont l'énergie minimale vaut E1.

Enfin, l'hétérostructure objet de l'invention peut comprendre plusieurs exemplaires empilés dudit motif, afin de former une structure à multipuits quantiques.

La présente invention sera mieux comprise à la lecture de la description d'exemples de réalisation donnés ci-après à titre purement indicatif et nullement limitatif, en faisant référence aux dessins annexés sur lesquels :

- la figure 1 est une représentation schématique d'un puits quantique et des fonctions d'onde $\phi1$ et $\phi2$ des états des deux premières sous-bandes et a déjà été décrite,
- la figure 2 représente les courbes de dispersion de ces deux premières sous-bandes et a déjà été décrite,
- la figure 3 représente schématiquement deux structures connues et deux structures conformes à l'invention en vue de comparer leurs performances,
- la figure 4 représente les variations de E1 en fonction de E2-E1 pour ces structures,
- la figure 5 montre les variations de E2-E1 en fonction de la largeur du puits pour chaque structure,
- la figure 6 représente les variations de la force d'oscillateur f12 en fonction de cette largeur du puits pour chaque structure,
- la figure 7A montre le potentiel effectif ressenti par un électron dans un multi-puits quantique GaAs/AlAs et la figure 7B représente les fonctions d'onde des premiers états d'électrons de la structure pour un puits étroit de GaAs,
- la figure 8 représente le potentiel effectif ressenti par des électrons dans un puits asymétrique GaAs/$Ga_xAl_{1-x}As$/ AlAs,
- la figure 9 représente les variations de f13 en fonction de E3-E1 pour le puits asymétrique de la figure 8,
- la figure 10 illustre schématiquement une hétérostructure connue,
- la figure 11 illustre schématiquement une hétérostructure conforme à l'invention pour la comparer à cette hétérostructure connue,
- les figures 12 et 13 permettent de comparer les performances de sept structures dont une est connue et les six autres sont conformes à l'invention, et
- la figure 14A illustre la configuration des extrémas de bandes dans le système InAs/GaSb/AlSb tandis que la figure 14B montre une structure InAs/GaSb/AlSb sous champ électrique.

Avant de décrire des modes de réalisation particuliers de l'invention, on revient sur les deux approches envisageables qui sont mentionnées plus haut.

La première approche consiste à réduire la largeur $\underline{a}$ du puits (voir fig.1) afin d'augmenter la distance entre SB1 et SB2.

En effet, les énergies E1 et E2 sont inversement proportionnelles au carré de $\underline{a}$ lorsque la hauteur Vb de la barrière de potentiel (profondeur du puits) est très supérieure à l'énergie E2.

De plus, la force d'oscillateur f12 de la transition de SB1 vers SB2 reste constante lorsque $\underline{a}$ diminue.

En conséquence, le pouvoir absorbant, à dopage donné du puits, est constant lorsque cette largeur diminue.

Pour un fonctionnement tel que E2-E1 soit supérieur à 500 meV, E2 est au moins à 750 meV du fond du puits.

Dans ces conditions, on peut utiliser deux systèmes, qui permettent d'avoir une discontinuité de bande de conduction Vb suffisamment élevée pour que Vb soit très supérieur à E2 c'est-à-dire dépasse E2 d'au moins 100 meV, à savoir le système GaAs (puits)/$Ga_xAl_{1-x}As$ (barrières) et le système GaSb (puits)/AlSb (barrières).

On considère d'abord le système GaAs/AlAs.

Avec ce système, trois problèmes essentiels se présentent.

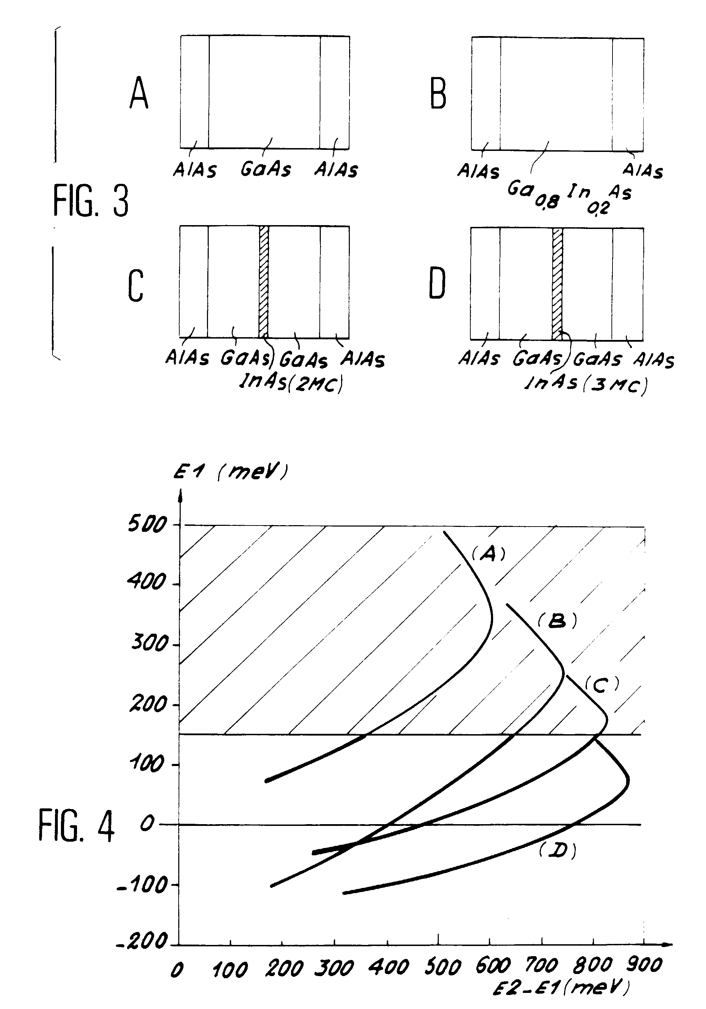

Ils sont illustrés par les figures 3 à 6 qui résument l'inter-dépendance des paramètres du puits (largeur, énergie de transition intra-bande, position de E1, force d'oscillateur f12 de SB1 vers SB2) pour diverses structures A, B, C et D (figure 3).

On considère les résultats obtenus pour la structure A qui se rapporte à un puits quantique GaAs/AlAs dont on fait varier la largeur.

On indique ci-après le premier problème qui se pose.

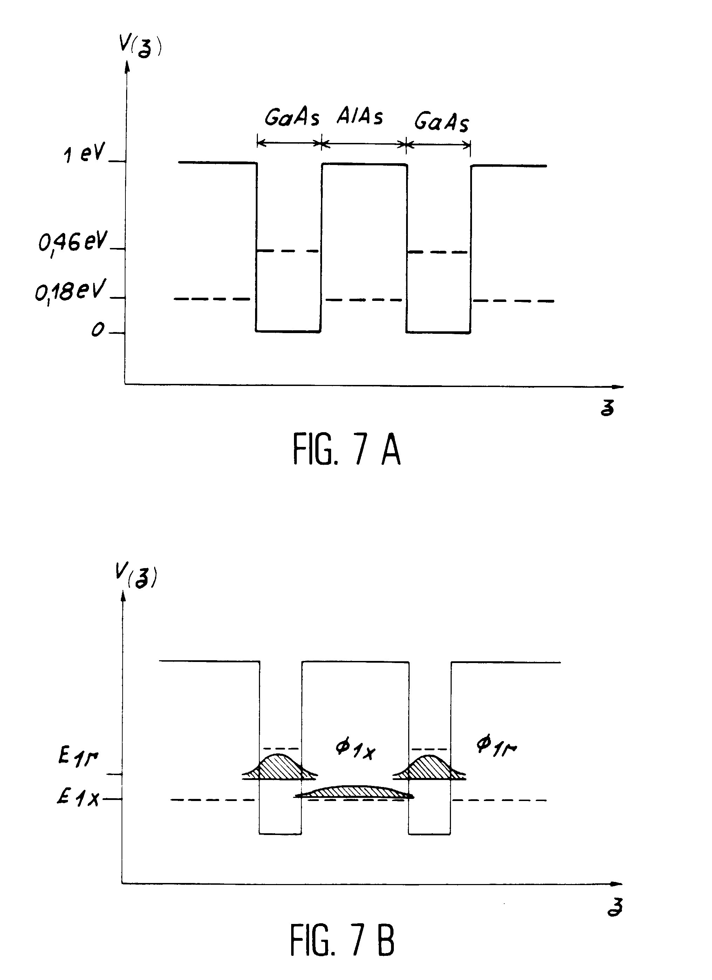

Les positions respectives des extréma de bandes aux points gamma et X de la zone de Brillouin sont représentées, pour un puits de GaAs dans AlAs, sur la figure 7A où les minima X sont en pointillés et les minima gamma en traits pleins.

La figure 7B montre les fonctions d'ondes des premiers états d'électrons de la structure pour un puits étroit de GaAs. Des électrons de la vallée X sont soumis à un puits de potentiel dans les couches de AlAs.

Les premiers niveaux de type X de la structure ont une énergie voisine de 180 meV par rapport au fond du puits.

On observe expérimentalement que si le puits a une largeur inférieure à 3,5 nm, le premier niveau électronique de conduction de la structure est le premier niveau de la famille X et non pas le niveau E1 de la structure (voir la fig.7B).

Alors, il n'est pas possible de peupler la sous-bande SB1 pour exploiter la transition de SB1 vers SB2.

Si l'on veut que E1 soit raisonnablement inférieur à X1 (X1-E1 supérieur à 30 meV), il n'est pas possible d'obtenir des énergies de transition intra-bande supérieures à 300 meV (voir la fig.4).

On précise que dans les structures de la figure 3, les barrières sont en AlAs et le puits est constitué d'une couche de GaAs (structure A), de $In_{0,2}Ga_{0,8}As$ (structure B), d'une couche de GaAs avec deux monocouches de InAs en son milieu (structure C conforme à l'invention) ou encore d'une couche de GaAs avec trois monocouches de InAs en son milieu (structure D conforme à l'invention).

Sur la figure 4, les variations de E1 en fonction de E2-E1 sont représentées et la droite E1=0,15 eV limite le domaine hachuré où ces structures ne peuvent être utilisées pour réaliser une opération efficace d'absorption intra-bande.

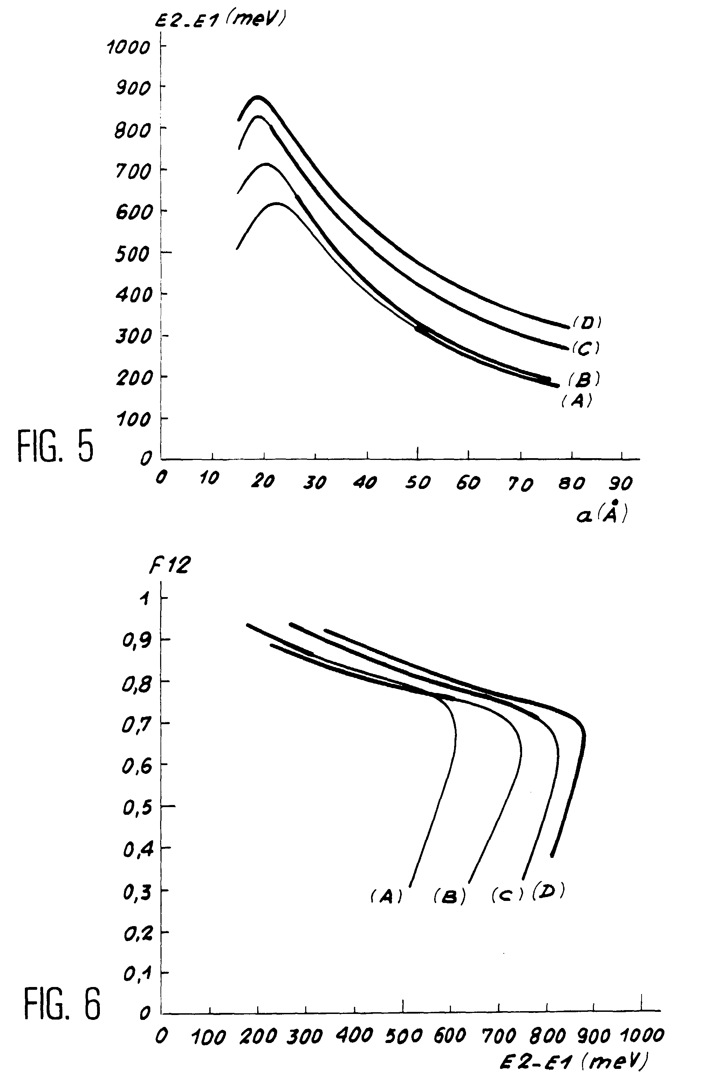

On indique aussi que, sur la figure 5, E2-E1 est donné en fonction de la largeur $\underline{a}$ du puits, les traits gras correspondant à la plage d'utilisation possible de ces puits quantiques.

Sur la figure 6, la force d'oscillateur f12 de la transition intra-bande est donnée en fonction de E2-E1, les traits gras correspondant à la plage d'utilisation possible de ces puits quantiques.

On expose maintenant le deuxième problème.

Lorsque la largeur du puits diminue, les effets de non-parabolicité de la masse effective m* deviennent importants.

A l'énergie E2, la masse effective est beaucoup plus lourde qu'en bas de bande.

Ceci limite l'augmentation de E2 ; la distance E2-E1 finit par saturer et décroître, lorsque la largeur du puits diminue.

La valeur maximale atteinte est de l'ordre de 600 meV (voir la figure 5, structure (A)).

Le troisième problème est le suivant : cette valeur maximale est atteinte pour des largeurs de puits très faibles (2,5 nm).

Les propriétés électroniques sont alors très sensibles à la qualité de la structure et à la perfection des interfaces en particulier.

Pour résoudre ces trois problèmes, on peut cheche à remplacer GaAs par un matériau semiconducteur de plus petite bande interdite, plus précisément $In_yGa_{1-y}As$.

Ce matériau a un paramètre de maille différent de GaAs mais peut cependant être déposé en couche mince contrainte sur GaAs.

La réalisation de structures de bonne qualité comportant une cinquantaine de ces puits peut être envisagée pour $\underline{y}$ au plus égal à 0,2.

Ce remplacement de matériau de puits conduit essentiellement à une translation d'ensemble de la structure de bande du puits vers les basses énergies.

Les résultats obtenus pour un puits de $In_{0,2}Ga_{0,8}As$ dans AlAs sont portés sur les figures 3 à 6 (structure (B)).

Le premier problème (position par rapport à X1) se trouve allégé par le déplacement d'ensemble des niveaux du puits.

Des énergies de transition de l'ordre de 600 meV sont a priori ainsi accessibles.

Ce problème mis à part, on note que l'effet de saturation sur E2-E1 (deuxième problème) est limité, E2 atteignant plus tard la plage d'énergie où l'alourdissement de la masse joue un rôle important.

Par contre, le troisième problème ne se trouve pas allégé : dans la plage des énergies de transition accessibles, la dépendance de E2-E1 en fonction de la largeur du puits est quasiment identique pour un puits de GaAs ou de $In_{0,2}Ga_{0,8}As$ (dans les deux cas, AlAs joue le rôle d'une barrière de hauteur infinie).

On considère maintenant le système GaSb/AlSb.

GaSb a une énergie de bande interdite de 0,75 eV à basse température, ce qui en fait un matériau intéressant pour l'optoélectronique.

AlSb joue le rôle d'une barrière, avec Vb=1,1 eV (très voisine de ce qu'elle vaut dans GaAs/AlAs).

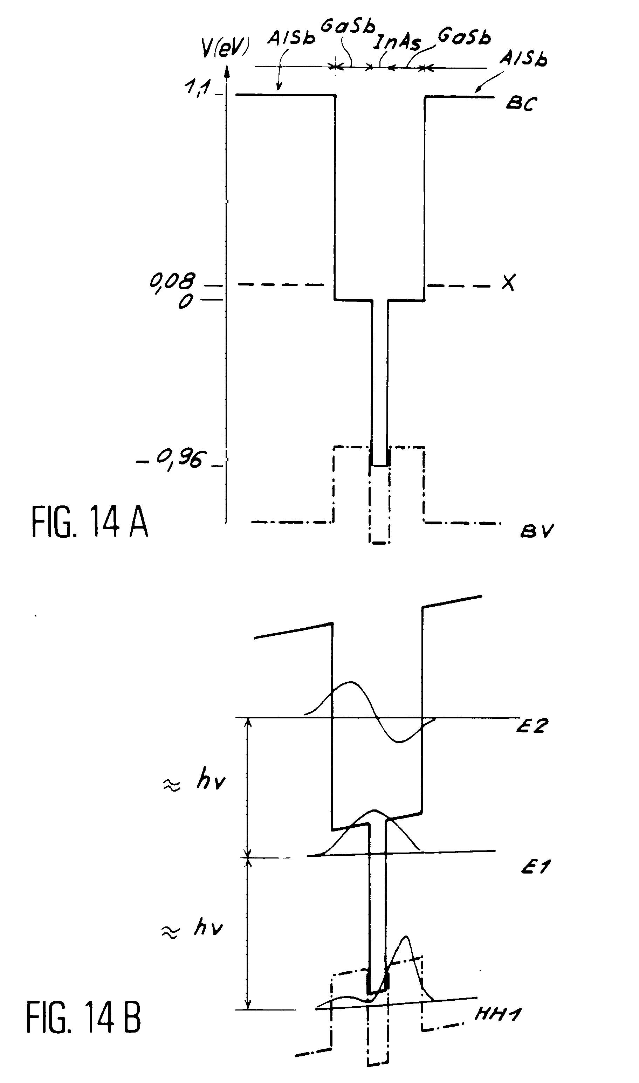

La configuration de bandes pour les matériaux GaSb, AlSb (et InAs utilisé dans des hétérostructures conformes à l'invention) est présentée sur la figure 14A où BV et BC représentent respectivement la bande de valence et la bande de conduction.

Pour des puits simples GaSb/AlSb, l'énergie de transition intrabande peut être au maximum de 150 à 200 meV : en effet, le minimum de la bande L de AlSb est placé 80 meV au dessus du minimum gamma de GaSb.

On retrouve donc ici le premier problème rencontré pour GaAs/AlAs.

Par ailleurs, l'écart énergétique E2-E1 sature à 0,6 eV puis décroît pour une largeur de puits inférieure à 2,8 nm.

On précise maintenant la seconde approche.

Dans le cadre de la recherche de transitions intrabandes efficaces à haute énergie, on peut également chercher à utiliser des transitions entre SB1 et SBn (n>2), plus élevées en énergie que SB2.

Mais la force d'oscillateur de ces transitions est beaucoup plus faible que celle de la transition fondamentale de SB1 vers SB2.

Ainsi, pour un puits quantique très profond (où Vb est très grand devant les énergies En considérées), la force d'oscillateur vaut :

0 si n est impair (par symétrie)

sinon

$$f1n = f12.(27/4).n^2.(n^2-1)^{-3}.$$

Cette force d'oscillateur décroît donc très vite : pour la transition de SB1 vers SB4, elle n'est déjà plus que de 3% de la force d'oscillateur de la transition fondamentale.

L'utilisation de puits asymétriques a déjà été proposée pour permettre (en rompant la symétrie) une transition de SB1 vers SB3.

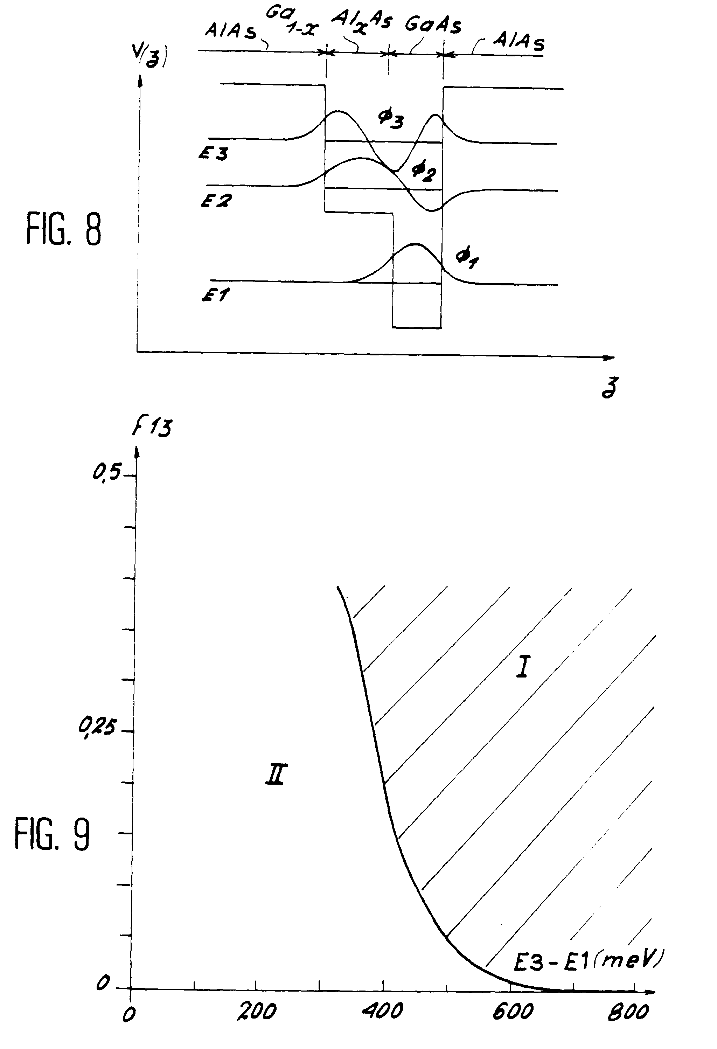

Une telle structure est présentée sur la figure 8 (où l'on voit le potentiel effectif V(z) ressenti par les électrons dans le puits et les premiers états de la structure) dans le cas du système GaAs/AlAs : le puits est constitué par une couche de GaAs et une couche d'alliage $Ga_xAl_{1-x}As$ (0<x<1), placées entre des couches-barrières de AlAs.

La figure 9 montre les variations de la force d'oscillateur f13 en fonction de l'énergie de transition E3-E1 ainsi que le domaine accessible II (le domaine hachuré I est inaccessible) en utilisant ce type de puits pour le système GaAs/AlAs.

On a fait varier x et les épaisseurs des couches constituant les puits, avec l'unique contrainte E1<0,15 eV ( traduisant comme précédemment la nécessité de pouvoir placer des électrons dans la sous-bande SB1).

On note que les forces d'oscillateur accessibles chutent fortement lorsque l'énergie de transition croît ; pour E = 0,5 eV, f13 vaut au mieux 5% de la force d'oscillateur f12 dans un puits quantique normal.

Pour un même dopage des puits et une même configuration d'opération, on devrait donc avoir 20 fois plus de puits asymétriques (opérant sur leur transition SB1 vers SB3) que de puits symétriques (opérant sur la transition SB1 vers SB2) pour une même absorption du rayonnement électromagnétique à l'énergie 0,5 eV.

Ces puits asymétriques n'apportent donc pas de solution performante au problème à résoudre (obtenir des transitions intrabandes efficaces à haute énergie).

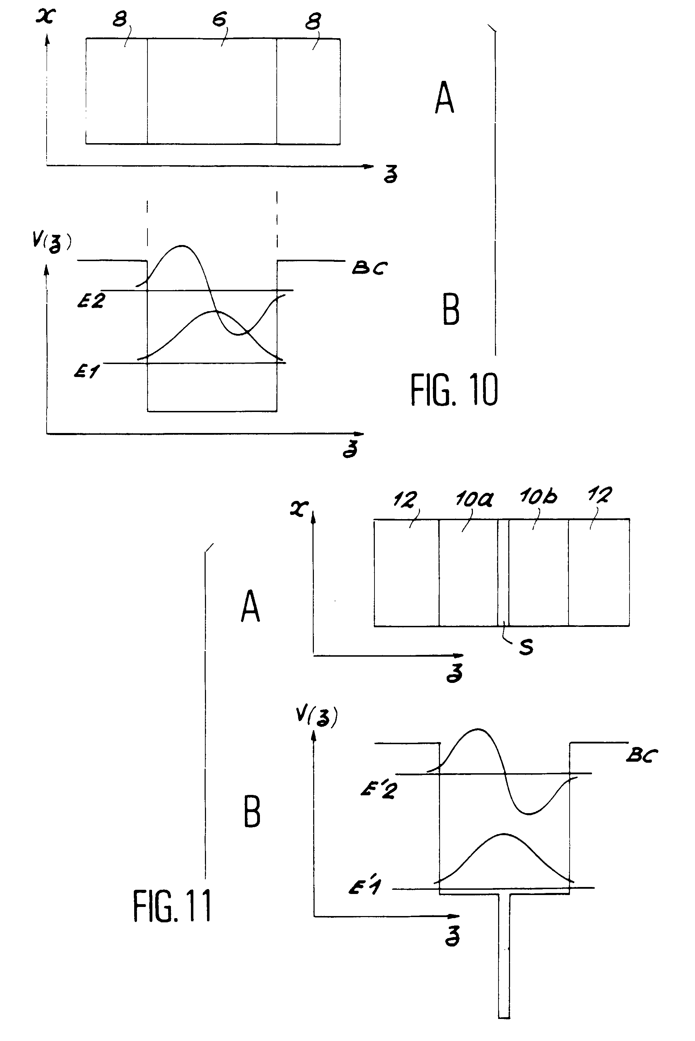

La figure 10 montre, dans sa partie A, une hétérostructure semiconductrice connue, du genre de celle de la figure 1 et comportant une couche de puits 6 entre deux couches barrières 8 pour former un puits quantique.

La partie B de la figure 10 montre la fonction d'onde des états des deux premières sous-bandes correspondantes dont les énergies minimales sont respectivement notées E1 et E2.

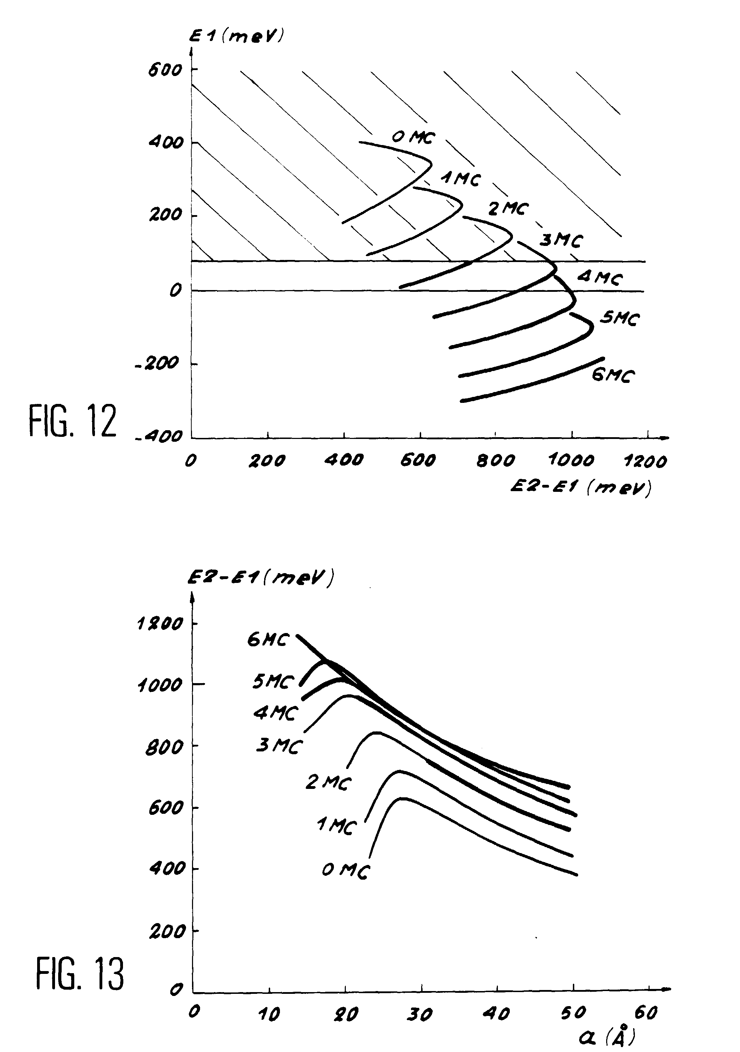

La figure 11 se rapporte à une hétérostructure conforme à l'invention.

L'invention repose en fait sur une observation mentionnée dans le document (6) de ce que la substitution d'une couche ultrafine du matériau du puits quantique par un matériau semiconducteur de la même famille (III-V ou II-VI par exemple) peut modifier de manière importante, et sélective, les positions énergétiques des différentes sous-bandes.

La figure 11 illustre ceci.

L'hétérostructure conforme à l'invention, représentée sur la partie A de la figure 11, comprend une couche de puits comprise entre deux couches-barrières ainsi qu'une couche S ultramince (composée de quelques monocouches), attractive et insérée au centre du puits obtenu.

Les couches-barrières portent la référence 12 et la couche de puits, dans laquelle est insérée la couche S, est donc en deux parties portant respectivement les références 10a et 10b.

Les techniques de croissance actuelles (épitaxie par jets moléculaires (EJM), épitaxie en phase vapeur à partir d'organo-métalliques (OMCVD)) permettent de contrôler le dépôt de couches très minces (quelques couches moléculaires, ou monocouches.

Dans les composés III-V une monocouche a une épaisseur de l'ordre de 0,3 nm.

On a représenté sur la partie B de la figure 11 le nouveau profil de potentiel du puits ainsi obtenu.

On voit que la position de la deuxième sous-bande n'est pas modifiée ou en tout cas très peu modifiée (l'énergie minimale de SB2, notée E'2, étant peu différente de E2) car la densité de probabilité de présence d'un électron de SB2 est nul au centre du puits et donc très faible dans la zone où le potentiel a été perturbé par l'insertion de la couche S : un électron ne perçoit pas cette perturbation.

Un électron de la sous-bande SB1 a, au contraire, une forte densité de probabilité de présence au centre du puits quantique.

Son énergie, notée E'1, est très inférieure à E1 du fait de l'insertion de la couche perturbatrice et attractive S.

On donne maintenant des exemples de réalisation de l'invention dans le cadre des systèmes GaAs/AlAs (c'est-à-dire $Ga_{1-x}Al_xAs$ pour la couche de puits et $Ga_{1-y}Al_yAs$ pour les couches-barrières, avec x positif ou nul et inférieur à y et y inférieur ou égal à 1) puis GaSb/AlSb (c'est-à-dire $Ga_{1-x}Al_xSb$ pour la couche de puits et $Ga_yAl_{1-y}Sb$ pour les couches-barrières, avec x positif ou nul et inférieur à y et y inférieur ou égal à 1).

Dans le cas du système GaAs/AlAs, on utilise par exemple InAs (ou plus exactement $In_zGa_{1-z}As$ avec z positif et inférieur ou égal à 1) pour réaliser la couche S qui perturbe la structure GaAs/AlAs.

InAs est un matériau de plus petite bande interdite que GaAs et permet de générer une perturbation attractive dans ce dernier.

Pour des questions de différence de paramètre de maille cristalline, on utilise une couche très mince de InAs comportant deux monocouches que l'on dépose sur GaAs par une technique de croissance classique (EJM ou OMCVD).

Certaines techniques dérivées de ces techniques de croissance classique permettent de déposer trois monocouches de InAs (voir les documents (7) et (8)).

On a comparé sur les figures 3 à 6 les résultats obtenus pour la structure GaAs/AlAs de référence à ceux obtenus pour des structures modifiées par l'insertion de deux monocouches MC (structure C) ou trois monocouches MC (structure D) de InAs au centre du puits.

Ces structures modifiées conformément à l'invention permettent de résoudre les trois problèmes mentionnés plus haut.

En ce qui concerne le premier problème, pour une énergie de transition donnée E2-E1, E1 est beaucoup plus faible pour la structure ainsi modifiée (voir la figure 4).

Dans toute la plage des énergies de transition, de 0 à 0,8 eV, E1 est inférieur à la limite de 0,15 eV : il est possible de peupler efficacement la sous-bande fondamentale de la structure.

En ce qui concerne le deuxième problème, l'effet de saturation de l'énergie de transition, dû à la non-parabolicité de la bande de conduction, est repoussé : pour E2-E1 donnée, E2 est en effet plus faible dans la structure modifiée.

La plage des énergies de transition a priori accessibles s'en trouve augmentée.

Une absorption intra-bande à des énergies dépassant 0,8 eV est rendue possible.

On notera que l'utilisation de trois monocouches de InAs au lieu de deux monocouches n'augmente pas tellement cette plage.

En ce qui concerne le troisième problème, pour une énergie de transition intrabande donnée, la largeur du puits est plus grande dans le cas de la structure modifiée.

Cette propriété peut permettre de travailler avec des puits de plus grande largeur (4 nm au lieu de 2,3 nm pour E2-E1=0,6 eV) et de meilleure qualité structurale.

On notera, pour chacun de ces trois problèmes, la supériorité des structures C et D conformes à l'invention sur la structure à puits de $In_{0,2}Ga_{0,8}As$.

On notera enfin, sur la figure 6, que les forces d'oscillateur sont supérieures, à énergie de transition intrabande donnée, pour les structures conformes à l'invention.

On précise que dans certain cas, il peut être plus intéressant de placer la couche S au voisinage du centre du puits plutôt que rigoureusement au centre de ce puits.

Pour les structures utilisées sous champ électrique, on pourra préférer placer la couche S au noeud de la fonction d'onde du second niveau (afin de déplacer celui-ci aussi peu que possible) ou au maximum de densité de propabilité de présence du premier niveau (pour abaisser celui-ci autant qu'il est possible).

On peut également compenser certaines imperfections de structure ; dans le cas de InAs dans GaAs et pour certaines conditions de croissance, on peut observer un étalement limité de InAs sur quelques monocouches, dans la direction de croissance.

Cet étalement décale alors la position moyenne de l'indium par rapport au centre du puits.

Ce déplacement peut être compensé par un décalage de la position nominale du plan de InAs.

On considère maintenant le cas du système GaSb/AlSb.

Dans ce cas, il est possible d'épitaxier facilement sur GaSb le matériau InAs.

Celui-ci a un fort caractère attractif pour les électrons car la discontinuité de bandes au voisinage de l'interface InAs/GaSb vaut 1 eV.

Pour mémoire, la configuration de bandes pour les matériaux InAs, GaSb et AlSb est représentée sur la figure 14A.

Une substitution de n monocouches (n supérieur ou égal à 2 et inférieur ou égal à 6) de GaSb par InAs au centre

EP 0 545 787 B1

du puits permet d'augmenter très fortement la plage des énergies de transition accessibles dans ce système, comme le montrent les figures 12 et 13 sur lesquelles les traits gras correspondent à la plage d'utilisation possible des puits quantiques.

De plus, sur la figure 13, $\underline{a}$ est la largeur d'un puits (épaisseur de GaSb plus épaisseur des n monocouches MC de InAs).

Pour n supérieur ou égal à 3, cette plage s'étend bien au-delà de 0,8 eV.

Un avantage de ce système par rapport au système InAs/GaAs/AlAs (utilisation de InAs pour former la couche S) est qu'on peut obtenir ici une valeur désirée E2-E1 en partant d'un puits plus large qui est donc plus facilement réalisable et moins sensible aux imperfections.

On notera que pour une largeur de puits donnée, E2-E1 augmente avec n, sature pour n égal à 4 ou à 5 et diminue ensuite.

L'effet majeur d'une augmentation de n, pour n supérieur ou égal à 4, est un déplacement d'ensemble des niveaux E1 et E2 vers les basses énergies et une réduction correspondante de l'énergie de bande interdite de la structure.

Un second avantage de ce système est donc qu'on peut ajuster relativement indépendamment si nécessaire l'énergie de transition intra-bande (très sensible à la largeur du puits) et l'énergie de bande interdite.

Pour la mise en oeuvre de l'invention dans le système GaSb/AlSb, on peut utiliser une couche S de InAs relativement épaisse, de l'ordre de 1,5 nm par exemple.

Comme autre matériau de substitution dans la structure, on pourrait utiliser InSb (deux ou trois monocouches) ou In(AsSb) au lieu de InAs.

On indique ci-après quelques modes particuliers de mise en oeuvre de l'invention.

L'insertion d'une couche mince au centre du puits conformément à l'invention ne change pas les conditions d'utilisation d'une telle structure utilisant l'absorption intrabande.

En particulier, les conditions sur la polarisation et la direction de propagation d'un faisceau lumineux incident sont inchangées.

Les techniques traditionnellement employées pour augmenter l'efficacité de l'absorption intra-bande par les puits (configuration de multi-réflexion, entrée du rayonnement par une face inclinée à 45° par rapport au plan des puits, insertion de la structure dans un guide d'onde, corrugation de la surface pour réaliser un réseau de diffraction) peuvent être de même employées ici.

Chaque fois qu'un composant utilise l'absorption intra-bande, il est donc possible d'étendre vers les courtes longueurs d'onde sa plage de fonctionnement en modifiant uniquement, conformément à l'invention, le puits (ou les puits dans le cas d'une structure à multipuits quantiques) où se produit l'absorption intra-bande.

Pour la présentation de quelques modes préférentiels de réalisation, on ne considère donc que la zone de la structure réalisant la fonction d'absorption intra-bande.

Exemple sur un substrat de GaAs :

| Epaisseur | Nature |
|---|---|
| $c_1$ | $Ga_x Al_{1-x} As$ $(0 < x \leq 1)$ non dopé |
| $b_1$ | $Ga_y Al_{1-y} As$ $(x \leq y \leq 1)$ non dopé |
| $p_2$ | GaAs |
| 2 MC | InAs dopage volumique par des donneurs (exemple : Si), densité n |
| $p_2$ | GaAs |
| $b_2$ | $Ga_z Al_{1-z} As$ $(x \leq z \leq 1)$ non dopé |
| $c_2$ | $Ga_x Al_{1-x} As$ $(0 \leq x \leq 1)$ non dopé |

En prenant x=0,3, y=z=1, $b_1$=$b_2$=3nm, $p_1$=$p_2$=1,8 nm et n=2,5x$10^{18}$ atomes/cm$^3$, on obtient une structure absorbant à 0,5 eV (2,5 micromètres), avec une densité surfacique électronique de $10^{12}$ électrons.cm$^{-3}$. Les épaisseurs $c_1$ et $c_2$ sont quelconques, par exemple 5 nm.

8

| Epaisseur | Nature |
|-----------|--------|
| $c_1$ | $Ga_xAl_{1-x}As$ ($0<x\leq1$) dopé par n atomes Si/cm$^3$ |
| $b_1$ | $Ga_yAl_{1-y}As$ ($x\leq y\leq1$) non dopé |
| $p_1$ | GaAs |
| 3 MC | InAs non dopé |
| $p_2$ | GaAs |
| $b_2$ | $Ga_zAl_{1-z}As$ ($x\leq z\leq1$) non dopé |
| $c_2$ | $Ga_xAl_{1-x}As$ ($0\leq x\leq1$) dopé par n atomes Si/cm$^3$ |

En prenant x=0,3, y=z=1, $b_1=b_2=3$ nm, $p_1=p_2=0,8$ nm, $c_1=c_2=5$ nm et n=$10^{18}$ atomes/cm$^3$, on a une absorption à environ 0,8 eV (1,55 micromètre). Les barrières de AlAs étant très fines, l'ensemble des électrons introduit par dopage est transféré dans le puits, dont la densité électronique est voisine de $10^{12}$ électrons.cm$^{-3}$.

Exemple sur un substrat de GaSb :

| Epaisseur | Nature |
|-----------|--------|
| $c_1$ | GaSb dopé par n atomes Si/cm$^3$ |
| $b_1$ | AlSb non dopé |
| $p_1$ | GaSb non dopé |
| 5 MC | InAs non dopé |
| $p_2$ | GaSb non dopé |
| $b_2$ | AlSb non dopé |
| $c_2$ | GaSb dopé par n atomes Si/cm$^3$ |

En prenant $b_1=b_2=3$ nm, $p_1=p_2=1,0$ nm, $c_1=c_2=5$ nm et n=$10^{18}$ atomes/cm$^3$, l'énergie de transition intrabande et l'énergie $E_1$-$HH_1$ de bande interdite de la structure sont simultanément très proches de 0,8 eV.

On peut donc intégrer sur un substrat de GaSb des fonctions de traitement du signal à 0,8 eV (1,55 micromètres) utilisant soit l'absorption intrabande soit l'absorption bande à bande.

Si l'on applique un champ électrique de l'ordre de $10^7$ V/m pour asymétriser cette structure, on obtient la configuration de bandes représentée sur la figure 14B.

Cette structure est bien adaptée à la génération de seconde harmonique à partir r d'un rayonnement de première harmonique à 1,55 micromètre (hv=0,8 eV) : on n'a qu'un seul terme résonant puique les niveaux d'électrons (ou de trous) sont bien séparés les uns des autres ; ce terme provient du processus mettant en jeu la première sous-bande de trous lourds (de fonction d'onde $\phi t$ et d'énergie minimale Et) et les deux premières sous-bandes d'électrons (de fonctions d'onde $\phi1$ et $\phi2$ et d'énergies minimales E1 et E2).

Le coefficient de génération de seconde harmonique est proportionnel à :

$$\frac{<\phi t|\phi2> <\phi2|z|\phi1> <\phi1|\phi t>}{(E2-Et-2hv)\ (E1-Et-hv)}$$

Les énergies de transition interbande (de l'ordre de 0,79 eV) et intrabande (de l'ordre de 0,81 eV) sont simultanément proches de la résonance à 0,8 eV.

De plus, les termes de recouvrement $<\phi1|\phi t>$ et $<\phi t|\phi2>$ sont grands (ils valent respectivement 0,63 et 0,42) et la force d'oscillateur de la transition intrabande (liée à l'élément de matrice $<\phi1|z|\phi2>$) est également grande (elle est voisine de 0,8).

On notera enfin qu'une version non dopée de la structure de l'invention peut constituer le milieu actif d'un modulateur tout optique, travaillant à 1,55 micromètre et commandé par un rayonnement de même longueur d'onde.

Les documents cités dans la présente description sont les suivants :

(1) Levine B.F., Choi K.K., Bethea C.G. Walker J. et Malik R.J., Appl. Phys. Lett. 50, 1092 (1987)

(2) Vodjani N., Vinter B., Berger V., Böckenhoff E. et Costard E., Appl. Phys. Lett. 59, 555 (1991)

(3) Olszakier et al, Phys. Rev. Lett., $\underline{62}$, 2997 (1989)

(4) Rosencher E., Bois P., Nagle J. et Delaître S., Electron. Lett. $\underline{25}$, 1063 (1989)

(5) Khurghin J., Phys Rev. B, $\underline{38}$, 4056 (1988)

(6) Marzin J.Y. et Gerard J.M., Phys. Rev. Lett. $\underline{62}$, 2172 (1989)

(7) Gerard J.M. et Marzin J.Y., Appl. Phys. Lett $\underline{53}$, 568 (1988)

(8) Lee J.H., Hsieh K.Y. et Kolbas R.M., Phys. Rev. B $\underline{41}$, 7678 (1990)

## Revendications

1. Hétérostructure semiconductrice de traitement d'un signal optique comprenant au moins un motif comportant une couche mince (10a, 10b) d'un matériau semiconducteur et deux couches-barrières semiconductrices (12) entre lesquelles se trouve la couche mince et qui ont une plus grande largeur de bande interdite que la couche mince, ce qui crée un puits de potentiel, cette hétérostructure comprenant en outre une couche ultrafine attractive (S) qui est composée de quelques monocouches, qui est insérée dans la couche mince, sensiblement au milieu de celle-ci, et qui est faite d'un matériau semiconducteur appartenant à la même famille que le matériau de la couche mince (10a, 10b) et ayant une largeur de bande interdite plus petite que celle de cette couche mince, l'hétérostructure étant caractérisée en ce qu'elle comporte au moins deux sous-bandes dont les états d'énergie minimale sont confinés dans le puits de potentiel et dont les énergies minimales sont respectivement notées E1 et E2, avec E2 supérieure à E1, la profondeur du puits de potentiel étant très supérieure à E2 et la distance entre les minima en énergie de ces sous-bandes étant au moins égale à 400 meV de façon à permettre l'absorption intra-bande de rayonnements d'énergie correspondante, la sous-bande dont l'énergie minimale vaut E1 étant susceptible d'être peuplée.

2. Hétérostructure selon la revendication 1, caractérisée en ce que les matériaux constitutifs de la couche mince (10a, 10b) et des couches (12) entre lesquelles cette couche mince se trouve appartiennent à la même famille de matériaux semiconducteurs.

3. Hétérostructure selon la revendication 2, caractérisée en ce que la couche mince (10a, 10b) est en $Ga_{1-x}Al_xAs$ et en ce que les couches (12) entre lesquelles se trouve cette couche mince sont en $Ga_{1-y}Al_yAs$, x étant positif ou nul et inférieur à y, y étant inférieur ou égal à 1.

4. Hétérostructure selon la revendication 3, caractérisée en ce que la couche ultrafine (S) est en $In_zGa_{1-z}As$, z étant supérieur à 0 et inférieur ou égal à 1.

5. Hétérostructure selon la revendication 2, caractérisée en ce que la couche mince (10a, 10b) est en $Ga_{1-x}Al_xSb$ et en ce que les couches entre lesquelles se trouve cette couche mince sont en $Ga_yAl_{1-y}Sb$, x étant positif ou nul et inférieur à y, y étant inférieur ou égal à 1.

6. Hétérostructure selon la revendication 5, caractérisée en ce que la couche ultrafine (S) est en InAs.

7. Hétérostructure selon l'une quelconque des revendications 1 à 6, caractérisée en ce qu'elle est dopée par des donneurs, de façon à peupler par des électrons le bas de la sous-bande dont l'énergie minimale vaut E1.

8. Hétérostructure caractérisée en ce qu'elle comprend un empilement de plusieurs hétérostructures selon l'une quelconque des revendications 1 à 7.

## Patentansprüche

1. Halbleiterheterostruktur für die Verarbeitung eines optischen Signals mit mindestens einem Grundelement, das eine dünne Schicht (10a,10b) aus einem Halbleitermaterial und zwei Halbleitersperrschichten (12) umfaßt, zwischen denen sich die dünne Schicht befindet und die eine größere Breite eines verbotenen Bandes aufweisen als die dünne Schicht, wodurch eine Potentialsenke geschaffen wird, wobei die Heterostruktur weiterhin eine ultrafeine anziehende Schicht (S) umfaßt, die aus mehreren Monoschichten zusammengesetzt ist, die in der dünnen Schicht ungefähr in der Mitte von dieser eingefügt ist, und die aus einem Halbleitermaterial gefertigt ist, das der selben Familie angehört wie das Material der dünnen Schicht (10a,10b), und eine Breite eines verbotenen Bandes aufweist, die kleiner als die der dünnen Schicht ist, wobei die Heterostruktur **dadurch gekennzeichnet ist, daß** sie mindestens zwei Unterbänder aufweist, deren minimale Energiezustände in der Potentialsenke enthalten sind und deren minimale Energie bezeichnet sind mit E1 bzw. E2, wobei E2 größer ist als E1, wobei die Tiefe der Potentialsenke weit über der von E2 liegt und der Abstand zwischen den Energieminima dieser Unterbanden mindestens gleich 400 meV ist, so- daß sie die Intrabandenabsorption von entsprechenden Energiestrahlen erlaubt, wobei das Unterband, dessen minimale Energie gleich E1 entspricht, geeignet ist, besetzt zu werden.

2. Heterostruktur nach Anspruch 1, **dadurch gekennzeichnet, daß** die Materialien, die die dünne Schicht (10a,10b) und die Schichten (12) bilden, zwischen welchen sich diese dünne Schicht befindet, zur selben Familie von Halbleitermaterialien gehören.

3. Heterostruktur nach Anspruch 2, **dadurch gekennzeichnet, daß** die dünne Schicht (10a,10b) aus $Ga_{1-x}Al_xAs$ besteht, und die Schichten (12), zwischen welchen sich diese dünne Schicht befindet, aus $Ga_{1-y}Al_yAs$ besteht, wobei x positif oder Null und kleiner als y ist, und y kleiner oder gleich 1 ist.

4. Heterostruktur nach Anspruch 3, **dadurch gekennzeichnet, daß** die ultrafeine Schicht (S) aus $In_zGa_{1-z}As$ besteht, wobei z größer als 0 und kleiner oder gleich 1 ist.

5. Heterostruktur nach Anspruch 2, **dadurch gekennzeichnet, daß** die dünne Schicht (10a,10b) aus $Ga_{1-x}Al_xSb$ besteht, und die Schichten (12), zwischen welchen sich diese dünne Schicht befindet, aus $Ga_yAl_{1-y}Sb$ besteht, wobei x positif oder Null und kleiner als y ist, und y kleiner oder gleich 1 ist.

6. Heterostruktur nach Anspruch 5, **dadurch gekennzeichnet, daß** die ultrafeine Schicht (S) aus InAs besteht.

7. Heterostruktur nach einem der Ansprüche 1 - 6, **dadurch gekennzeichnet, daß** sie mit Donatoren derart dotiert ist, daß der Boden des Unterbandes, dessen Energie gleich E1 ist, von Elektronen bevölkert ist.

8. Heterostruktur **dadurch gekennzeichnet, daß** sie eine Aufeinanderschichtung von mehreren Heterostrukturen gemäß einem der Ansprüche 1 bis 7 umfaßt.

## Claims

1. Semiconductor heterostructure for processing an optical signal, comprising at least one pattern including a thin film (10a, 10b) of a semiconductor material and two semiconductor barrier layers (12) between which the thin film is located and which have a larger band gap than the thin film, which creates a potential well, this heterostructure furthermore comprising an attractive ultrathin film (S) which is composed of a few monolayers, which is inserted into the thin film, substantially at the centre of the latter, and which is made of a semiconductor material belonging to the same family as the material of the thin film (10a, 10b) and has a band gap smaller than that of the thin film, the heterostructure being characterized in that it includes at least two sub-bands whose minimum energy states are confined in the potential well and whose minimum energies are respectively denoted E1 and E2, with E2 greater than E1, the depth of the potential well being very much greater than E2, and the distance between the energy minima of these sub-bands being at least equal to 400 meV so as to allow the intraband absorption of radiation with corresponding energy, the sub-band whose minimum energy is equal to E1 being capable of being populated.

2. Heterostructure according to Claim 1, characterized in that the materials constituting the thin film (10a, 10b) and the layers (12) between which this thin film is located belong to the same family of semiconductor materials.

3. Heterostructure according to Claim 2, characterized in that the thin film (10a, 10b) is made of $Ga_{1-x}Al_xAs$, and in that the layers (12) between which this thin film is located are made of $Ga_{1-y}Al_yAs$, x being positive or zero and less than y, y being less than or equal to 1.

4. Heterostructure according to Claim 3, characterized in that the ultrathin film (S) is made of $In_xGa_{1-z}As$, z being greater than 0 and less than or equal to 1.

5. Heterostructure according to Claim 2, characterized in that the thin film (10a, 10b) is made of $Ga_{1-x}Al_xSb$, and in that the layers between which this thin film is located are made of $Ga_yAl_{1-y}Sb$, x being positive or zero and less than y, y being less than or equal to 1.

6. Heterostructure according to Claim 5, characterized in that the ultrathin film (S) is made of InAs.

7. Heterostructure according to any one of Claims 1 to 6, characterized in that it is doped with donors so as to populate with electrons the bottom of the sub-band whose minimum energy is equal to E1.

8. Heterostructure, characterized in that it comprises a stack of a plurality of heterostructures according to any one of Claims 1 to 7.

FIG. 1

FIG. 2

FIG. 3

A — AlAs GaAs AlAs

B — AlAs $Ga_{0,8} In_{0,2} As$ AlAs

C — AlAs GaAs GaAs AlAs InAs(2MC)

D — AlAs GaAs GaAs AlAs InAs(3MC)

FIG. 4

E1 (meV) vs E2-E1 (meV)

FIG. 5

FIG. 6

FIG. 7 A

FIG. 7 B

FIG. 8

FIG. 9

FIG. 10

FIG. 11

FIG. 12

FIG. 13

FIG. 14 A

FIG. 14 B